# EUROPÄISCHE PATENTSCHRIFT

(11) **EP 0 407 639 B1**
(45) Veröffentlichungstag und Bekanntmachung des Hinweises auf die Patenterteilung: **10.04.1996**
(21) Anmeldenummer: 89112816.7
(22) Anmeldetag: 13.07.1989
(51) Int. Cl.: G06F 3/05, G01D 18/00, G01R 35/00

(54) **Verfahren zur Einstellung von elektronischen Schaltungen**
Method of preadjusting electronic circuits
Procédé de mise au point de circuits électroniques

(43) Veröffentlichungstag der Anmeldung: 16.01.1991
(73) Patentinhaber: FEV Motorentechnik GmbH & Co. KG, D-52078 Aachen (DE)
(72) Erfinder: Schmitz, Günter, Dr.-Ing., D-5100 Aachen (DE)
(74) Vertreter: Langmaack, Jürgen, Dipl.-Ing.

(56) Entgegenhaltungen:
- EP-A- 0 084 247
- EP-A- 0 219 386
- DE-A- 3 610 170
- GB-A- 2 054 301
- GB-A- 2 197 957

## Beschreibung

Die Erfindung bezieht sich auf ein Verfahren zur Einstellung von elektronischen Schaltungen, welche einen oder mehrere Widerstände und einen oder mehrere Prozessoren enthalten.

Bei zahlreichen elektronischen Schaltungen ist für jedes produzierte Exemplar ein separater Abgleich zur Korrektur von Bauteiltoleranzen oder auch zur Abstimmung auf spezifische Anforderungen notwendig. Zu diesem Zweck wird häufig ein Abgleich von einem oder mehreren elektronischen Bauteilen, wie z.B. Kondensatoren, vorgenommen.

Bei elektronischen Schaltungen, die einen Prozessor enthalten, kann der Aufwand durch Verwendung von elektronisch programmierbaren Bausteinen, wie z.B. PROM oder EPROM, reduziert werden (siehe z.B. GB-A-2 197 957), indem die Anpassung jedes Exemplars durch Einprogrammieren von entsprechenden Parametern durchgeführt wird (Band-Ende-Programmierung). Dies erfordert allerdings das Vorhandensein solcher einzeln programmierbarer Bausteine, deren Kosten deutlich über denen eines z.B. maskenprogrammierten Bausteins liegen.

Aus GB-A-2 054 301 ist eine Anordnung bekannt, in der ein einstellbarer Widerstandswert über einen ADU laufend in einen Prozessor eingelesen wird, um Einstellungen vorzunehmen.

Der Erfindung liegt die Aufgabe zugrunde, eine kostengünstige und flexible Programmierung auch bei ausschließlicher Verwendung von festen Programmspeichern, wie maskenprogrammierbaren ROMs, zu ermöglichen.

Diese Aufgabe wird durch die Merkmale des Anspruchs 1 gelöst.

Aufgrund des besonders einfachen Widerstandsabgleichs ist eine "Programmierunq" von Parametern möglich, auf die der Prozessor ähnlich wie bei der PROM-Lösung zugreifen kann.

Ausführungsbeispiele der Erfindung werden nachfolgend anhand der Zeichnungen beschrieben.

Fig. 1 zeigt eine Schaltung zur Durchführung des Verfahrens.

Fig. 2 und 3 zeigen Schaltungen zur Messung der Dielektrizitätszahl eines unbekannten Mediums.

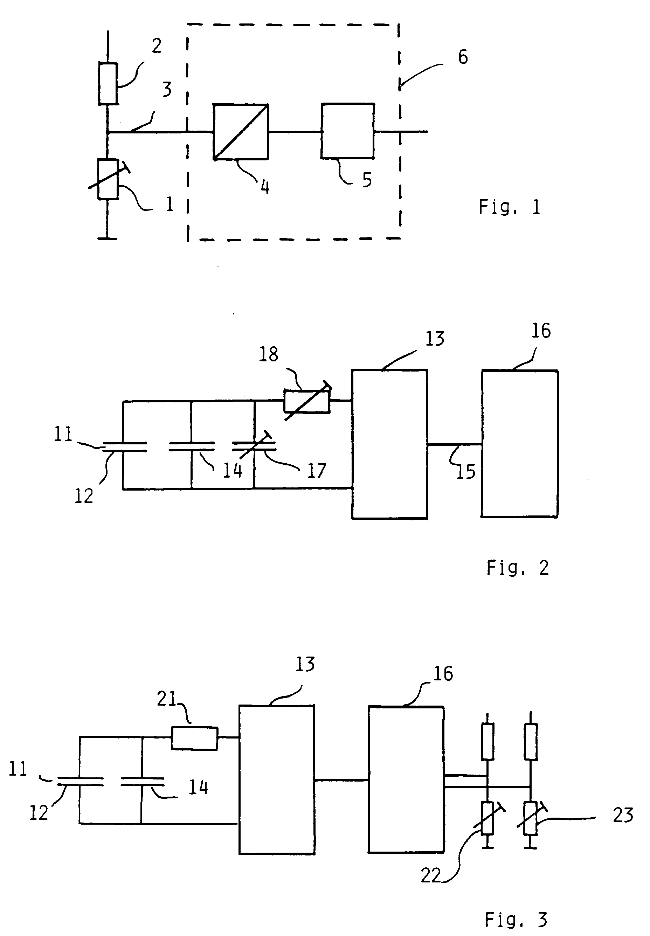

Wie Fig. 1 zeigt, wird von Widerständen 1 und 2 ein Spannungsteiler gebildet, dessen Ausgangsspannung auf Leitung 3 über einen Analog/Digital-Umsetzer 4 einem Prozessor 5 zum Einlesen weitergegeben wird.

Besondere Vorteile bezüglich der kostengünstigen Realisierung sind erreichbar, wenn der Analog/Digital-Umsetzer 4 mit dem Prozessor 5 zusammen in einem Mikro-Controller 6 integriert ist.

Vorteile gegenüber einem direkten Abgleich der elektronischen Schaltung lassen sich auch erzielen, wenn durch eine formelmäßige Berücksichtigung der eingestellten Farameter ein aufwendiger iterativer Einstellvorgang entfällt, oder wenn hierdurch eine aufwendige Einstellung mittels Trimmkondensator durch den Widerstandsabgleich ersetzt werden kann.

Beispielsweise ist in Figur 2 eine Schaltung zur Messung der Dielektrizitätszahl eines unbekannten Mediums dargestellt, wobei das Medium das Dielektrikum 11 eines Kondensators 12 bildet, der das frequenzbestimmende Glied in einem RC-Schwingkreis 13 ist. Bedingt durch Fertigungsstreuungen schwankt sowohl die von der Dielektrizitätszahl abhängige Kapazität 12 als auch die von der Dielektrizitätszahl unabhängige parasitäre Kapazität 14. Um nun einen Abgleich der Ausgangsfrequenz auf Leitung 15, die einer Weiterverarbeitungsschaltung 16 zugeführt wird, über den gesamten Meßbereich vornehmen zu können, ist ein Abgleich mit Hilfe von zwei einstellbaren Komponenten, nämlich einem Parallelkondensator 17 und einem Trimmwiderstand 18, erforderlich. Der Abgleich kann nur über einen iterativen Prozess erfolgen; das bedeutet, daß die Meßkapazität wechselweise mit Medien verschiedener Dielektrizitätszahl befüllt werden muß und jeweils ein Abgleich des Kondensators 17 bei Vorhandensein einer niedrigen Dielektrizitätszahl und der Widerstandstrimmer 18 bei Vorhandensein eines Mediums mit hoher Dielektrizitätszahl eingestellt werden muß, und zwar so lange, bis keine deutliche Verbesserung der Einstellung mehr erzielt werden kann.

In der Ausführungsform gemäß Figur 3 kommt das Verfahren gemäß der Erfindung zur Anwendung. Hierbei kann der Trimmkondensator 17 (Fig. 2) entfallen und der Trimmwiderstand 18 (Fig. 2) in einen Festwiderstand 21 umgewandelt werden. Der Abgleich erfolgt nun in der Weise, daß einmal eine Frequenzmessung mit einem Medium niedriger Dielektrizitätszahl (z.B. Luft) und eine zweite Messung mit einem Medium besonders hoher Dielektrizitätszahl durchgeführt wird. Das Ergebnis der Frequenzmessung wird durch Trimmung von zwei Widerständen 22 und 23 dem Prozessor eingegeben, so daß er dann bei zukünftigem Betrieb durch eine entsprechende formelmäßige Berücksichtigung eine Kompensation der Serienstreuung vornehmen kann.

Für die Großserienfertigung sind besondere Vorteile erzielbar durch den Einsatz eines Widerstands-Laser-Trimmverfahrens, das bei der konventionellen Technik aus zwei Gründen nicht eingesetzt werden könnte. Zum einen gibt es keine sinnvolle Möglichkeit, einen Kondensator durch Lasertrimmung abzugleichen, und zum anderen ist verfahrensbedingt bei der Lasertrimmung ein iterativer Abgleich nicht möglich (Abgleich durch teilweises Wegbrennen der Widerstandsbahnen).

Ebenfalls sehr vorteilhaft kann das der Erfindung zugrunde liegende Verfahren verwendet werden, um für jedes Exemplar einer Serie eine Anpassung an den spezifischen Anwendungsfall vorzunehmen. So kann z.B. durch Kodieren mit verschiedenen Analogwerten eine Auswahl von Ausgangskennlinien vorgenommen werden.

Weiterhin läßt sich ein einzeln programmierbarer Baustein einsparen für eine Programmierung einer Seriennummer, Chargennummer, einer Produkttypenkennzeichnung oder für die Realisierung eines Softwareschutzes, indem die Parameter wiederum durch Widerstandstrimmung eingestellt und über A/D-Umsetzer dem Prozessor zur Verfügung gestellt werden.

Besonders vorteilhaft ist der Einsatz dieser gesamten Verfahren in der Hybridtechnik, wo insbesondere die Lasertrimmung zum Tragen kommt. Solche Hybridschaltungen können besonders vorteilhaft in die Gehäuse von Sensoren integriert werden, die durch Kompensation der Typenstreuung und z.B. Anpassung der Ausgangskennlinie des Sensors durch den Prozessor an die spezifische Anwendung ein unmittelbar weiterverwendbares Signal zur Verfügung stellen.

## Patentansprüche

1. Verfahren zur Einstellung elektronische Meßschaltungen, die wenigstens einen einstellbaren Widerstand und wenigstens einen Prozessor enthalten, gekennzeichnet durch die Verfahrensschritte, daß der Widerstand auf einen vorgebbaren Wert der im späteren Betrieb zu messenden Größe eingestellt wird, daß der eingestellte, einem Parameter der Messung im späteren Betrieb der Schaltung entsprechende Widerstandswert dem Prozessor mittels eines A/D-Konverters ständig zum Einlesen zur Verfügung steht, und daß bei Messungen unbekannter Werte der zu messenden Größe im späteren Betrieb der Schaltung zur Korrektur des Ausgangssignals der Meß-schaltung der eingestellte Widerstandswert eingelesen und berücksichtigt wird.

2. Verfahren nach Anspruch 1, dadurch gekennzeichnet, daß wenigstens ein Parameter zur Kompensation von Serientoleranzen verwendet wird.

3. Verfahren nach Anspruch 1, dadurch gekennzeichnet, daß wenigstens ein Parameter zur Anpassung an unterschiedliche Anwendungen verwendet wird.

4. Verfahren nach Anspruch 1, dadurch gekennzeichnet, daß wenigstens ein Parameter zur Kennzeichnung der Schaltung verwendet wird, z.B. der Seriennummer, der Chargennummer, der Produkttype oder des Softwareschutzes.

5. Verfahren nach einem der Ansprüche 1-4, dadurch gekennzeichnet, daß die Einstellung wenigstens eines Widerstandes durch Lasertrimmung erfolgt.

6. Verfahren nach einem der Ansprüche 1-5, dadurch gekennzeichnet, daß wenigstens ein Parameter formelmäßig verarbeitet wird.

7. Verfahren nach einem der Ansprüche 1-6, dadurch gekennzeichnet, daß die elektronische Schaltung mit einem Meßwertaufnehmer in einem gemeinsamen Gehäuse untergebracht wird.

## Claims

1. A procedure for adjusting electronic measuring circuits which contain at least one adjustable resistance and at least one processor, characterised by the procedural steps that the resistance is adjusted to a predeterminable value of the quantity to measured in subsequent operation, that by means of an analogue-digital converter the adjusted resistance value corresponding to a parameter of measurement in subsequent operation of the circuit is permanently available to the processor for reading in, and that the adjusted resistance value is read in and taken into consideration during measurements of unknown values of the quantity to be measured in subsequent operation of the circuit for the correction of the output signal of the measuring circuit.

2. A procedure according to claim 1, characterised in that at least one parameter is used for the compensation of production tolerances.

3. A procedure according to claim 1, characterised in that at least one parameter is used for adapting to different applications.

4. A procedure according to claim 1, characterised in that at least one parameter is used for the identification of the circuit, e.g. of the serial number, the batch number, the product type or the software protection.

5. A procedure according to any one of claims 1-4, characterised in that the adjustment of at least one resistance is effected by laser trimming.

6. A procedure according to any one of claims 1-5, characterised in that at least one parameter is processed according to a formula.

7. A procedure according to any one of claims 1-6, characterised in that the electronic circuit is accommodated in a common housing with a measured value sensor.

## Revendications

1. Procédé pour mettre au point des circuits de mesure électroniques qui comprennent au moins une résistance réglable et au moins un processeur, caractérisé par les étapes suivantes : la résistance est réglée sur une valeur préalablement définie de la grandeur à mesurer au cours du fonctionnement ultérieur ; la valeur de résistance réglée correspondant à un paramètre de la mesure effectuée ultérieurement au cours du fonctionnement du circuit est mise à disposition en permanence par un convertisseur A/N pour que le processeur puisse la lire ; lorsque des mesures de la grandeur à mesurer qui sont effectuées ultérieurement pendant le fonctionnement du circuit révèlent des valeurs inconnues, la valeur sur laquelle la résistance a été réglée est prise en compte pour corriger le signal de sortie du circuit de mesure.

2. Procédé selon la revendication 1, caractérisé en ce que l'on utilise au moins un paramètre pour compenser des tolérances de série.

3. Procédé selon la revendication 1, caractérisé en ce que l'on utilise au moins un paramètre pour adapter le circuit à différentes applications.

4. Procédé selon la revendication 1, caractérisé en ce que l'on utilise au moins un paramètre pour caractériser le circuit, par ex. le numéro de série, le numéro de charge, les types de produits ou la protection du logiciel.

5. Procédé selon l'une des revendications 1 à 4, caractérisé en ce que la mise au point d'au moins une résistance s'effectue par ajustement au laser.

6. Procédé selon l'une des revendications 1 à 5, caractérisé en ce qu'au moins un paramètre est traité comme une formule.

7. Procédé selon l'une des revendications 1 à 6, caractérisé en ce que le circuit électronique est logé avec un capteur dans un boîtier commun.
